# EUROPEAN PATENT APPLICATION

(11) **EP 4 844 809 A1**
(43) Date of publication of application: **25.11.2026**
(21) Application number: 25178276.9
(22) Date of filing: 22.05.2025
(51) Int. Cl.: H01L 23/48, H01L 23/538, B22F 7/04

(54) **ARRANGEMENT AND METHOD FOR PRODUCING THE SAME**

(71) Applicant: Infineon Technologies AG, 85579 Neubiberg (DE)
(72) Inventor: OTTO, Frederik, 59399 Olfen (DE); LINK, Simon, 73655 Plüderhausen (DE); MÖLLER, Eike, 59558 Lippstadt (DE); SPECKELS, Roland, 59174 Kamen (DE)
(74) Representative: Westphal, Mussgnug & Partner, Patentanwälte mbB

(57) **Abstract**

An arrangement comprises a first connection partner (90), a second connection partner (92), and a connection layer (60) arranged between the first connection partner (90) and the second connection partner (92), and mechanically connecting the second connection partner (92) to the first connection partner (90), wherein the connection layer (60) comprises a first sinter layer (602), a metal layer (604), and a second sinter layer (606), wherein the first sinter layer (602) is arranged between the metal layer (604) and the first connection partner (90) and directly contacts the first connection partner (90), and the second sinter layer (606) is arranged between the metal layer (604) and the second connection partner (92) and directly contacts the second connection partner (92).

## Description

### TECHNICAL FIELD

The instant disclosure relates to an arrangement, in particular an arrangement comprising two connection partners connected to each other, and to a method for producing the same.

### BACKGROUND

Power semiconductor module arrangements often include a base plate within or forming a base surface of a housing. At least one substrate is arranged on the base plate. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and, optionally, a second metallization layer deposited on a second side of the substrate layer. The controllable semiconductor elements are mounted, for example, on the first metallization layer. The second metallization layer is usually attached to the base plate by means of a connection layer, e.g., a solder layer or a sintered layer. The base plate, the connection layer, and the substrate generally consist of different materials and, therefore, have substantially different coefficients of thermal expansion, CTEs. The substantially different CTEs of the different components, during the use of the semiconductor module arrangement, may lead to unintentional crack formation in the connection layer (e.g., solder layer or sintered layer) between the base plate and the substrate. Such cracks may lead to a reduced lifetime and early failure of the semiconductor module arrangement.

There is a need for an arrangement comprising two connection partners attached to each other by means of a connection layer that is more robust and has an increased lifetime, and for a method for producing the same.

### SUMMARY

An arrangement according to embodiments of the present disclosure includes a first connection partner, a second connection partner, and a connection layer arranged between the first connection partner and the second connection partner, and mechanically connecting the second connection partner to the first connection partner, wherein the connection layer includes a first sinter layer, a metal layer, and a second sinter layer, wherein the first sinter layer is arranged between the metal layer and the first connection partner and directly contacts the first connection partner, and the second sinter layer is arranged between the metal layer and the second connection partner and directly contacts the second connection partner.

A method according to embodiments of the present disclosure includes forming a connection layer between a first connection partner and a second connection partner, and mechanically connecting the second connection partner to the first connection partner by means of the connection layer, wherein the connection layer includes a first sinter layer, a metal layer, and a second sinter layer, wherein the first sinter layer is arranged between the metal layer and the first connection partner and directly contacts the first connection partner, and the second sinter layer is arranged between the metal layer and the second connection partner and directly contacts the second connection partner.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a semiconductor module arrangement.
Figure 2 schematically illustrates a cross-sectional view of an arrangement according to embodiments of the disclosure.
Figure 3 schematically illustrates a cross-sectional view of an arrangement according to further embodiments of the disclosure.
Figure 4 schematically illustrates a cross-sectional view of an arrangement according to even further embodiments of the disclosure.
Figure 5 schematically illustrates a cross-sectional view of a connection layer of an arrangement according to embodiments of the disclosure.
Figure 6 schematically illustrates a cross-sectional view of a connection layer of an arrangement according to further embodiments of the disclosure.
Figure 7, including Figures 7A to 7D, schematically a method for producing an arrangement according to embodiments of the disclosure.

### DETAILED DESCRIPTION

In the following detailed description, reference is made to the accompanying drawings. The drawings show specific examples of how the invention can be implemented. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to denote different "elements". That is, e.g., the existence of a "third element" does not necessarily require the existence of a "first element" or a "second element". An electrical line or electrical connection as described herein may be a single electrically conductive element, or include at least two individual electrically conductive elements connected in series and/or parallel. Electrical lines and electrical connections may include metal and/or semiconductor material and may be permanently electrically conductive (i.e., non-switchable). A semiconductor body as described herein may be made of (doped) semiconductor material and may be a semiconductor chip or be included in a semiconductor chip. A semiconductor body has electrically connectable pads and includes at least one semiconductor element with electrodes.

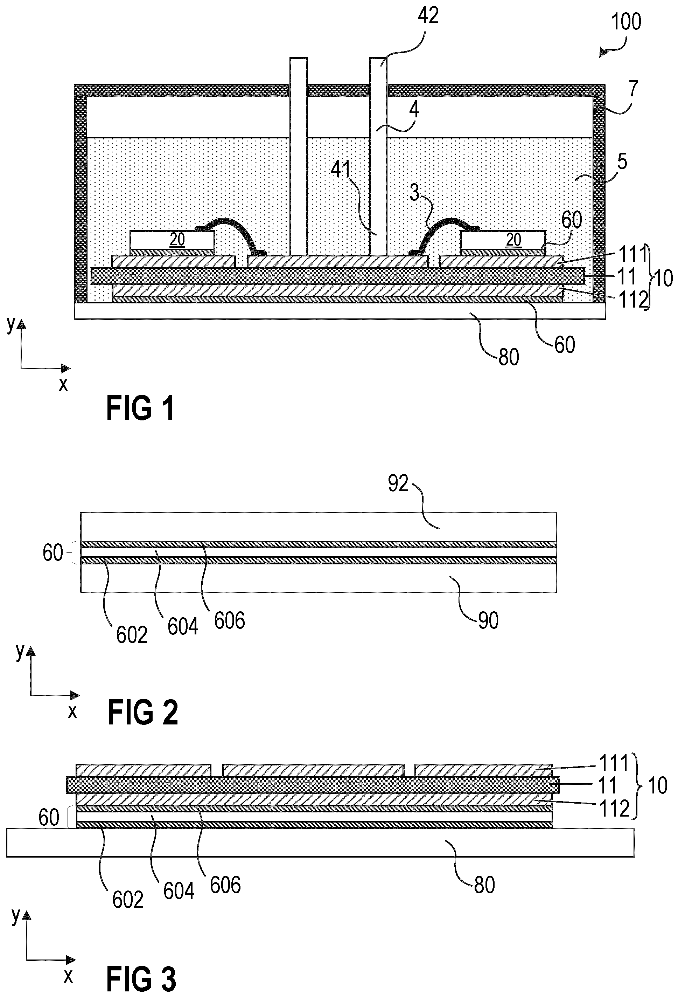

Referring to Figure 1, a cross-sectional view of a semiconductor module arrangement 100 is illustrated. The semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; gold; a gold alloy; nickel; a nickel alloy; silver; a silver alloy; any other metal or alloy that remains solid during the operation of the semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AIN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, SiN or BN and may have a diameter of between about 1µm and about 50µm. The substrate 10 may also be a conventional printed circuit board (PCB) that has a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 80 which forms a base surface of the housing 7, while the housing 7 itself solely comprises sidewalls and (optionally) a cover. In some semiconductor module arrangements 100, more than one substrate 10 is arranged on the same base plate 80 and within the same housing 7. The base plate 80 may comprise a layer of a metallic material such as, e.g., copper or AlSiC. Other materials, however, are also possible. The substrate 10 may be attached to the base plate 80 by means of a connection layer 60. The connection layer 60 may be a solder layer, a layer of an (electrically conductive) adhesive, or a layer of a sintered metal powder, e.g., a sintered silver (Ag) powder or a sintered copper (Cu) powder, for example. It should be noted that while there are various connection layers 60 identified throughout this application, each of these connection layers 60 may be but need not be identical. In Figure 1, for example, the chip connection layer 60 and the base-substrate connection layer 60 might both be sintered or soldered, or one of them might be sintered and the other soldered.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by electrically conductive connection layers 60. Such electrically conductive connection layers 60 may be solder layers, layers of an electrically conductive adhesive, or layers of a sintered metal powder, e.g., a sintered silver (Ag) powder or a sintered copper (Cu) powder, for example.

The semiconductor module arrangement 100 illustrated in Figure 1 further includes terminal elements 4. The terminal elements 4 provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second ends 42. Arranging the terminal elements 4 centrally on the substrate 10, as illustrated in Figure 1, is only an example. According to other examples, terminal elements 4 may be arranged closer to or adjacent to the sidewalls of the housing 7. The first end 41 of a terminal element 4 may be electrically and mechanically connected to the substrate 10 by means of an electrically conductive connection layer (not specifically illustrated for the terminal elements 4 in Figure 1), for example. Such an electrically conductive connection layer may be a solder layer, a layer of an electrically conductive adhesive, or a layer of a sintered metal powder, e.g., a sintered silver (Ag) powder or a sintered copper (Cu) powder, for example. Alternatively, the terminal elements 4 could be directly bonded to the substrate 10 via, for example, laser welding or ultrasonic welding or by directly sintering pre-structured / roughened sinterable surfaces without the need of a dedicated sintering material.

The semiconductor module arrangement 100 may further include an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 42, however, are not covered by the encapsulant 5 and protrude from the encapsulant 5 through the housing 7 to the outside of the housing 7. The encapsulant 5 is configured to protect the components and electrical connections of the semiconductor module arrangement 100, in particular the components arranged inside the housing 7, from certain environmental conditions and mechanical damage and to provide electrical insulation between areas of different electrical potential within the module. It is generally also possible to omit the housing 7 and solely protect the substrate 10 and any components mounted thereon with an encapsulant 5. In this case, the encapsulant 5 may be formed from a rigid material, for example.

During the operation of the semiconductor module arrangement 100 with the one or more semiconductor bodies 20 arranged on the substrate 10, the semiconductor bodies 20 produce heat. In particular, a flow of a (load) current I_{L} through the semiconductor bodies 20 results in a heating of the semiconductor bodies 20 (conduction and power losses). In general, the temperatures are higher, the longer the duration of the current flow. The heat is transferred from the semiconductor bodies 20 through the connection layer 60 to the substrate 10, and from there through the further connection layer 60 to the base plate 80. From there, heat may optionally be further transferred to a heat sink (not specifically illustrated in Figure 1).

When heated, the different components such as the semiconductor bodies 20, the substrate 10, the connection layers 60, and the base plate 80, expand to a certain degree. The components subsequently contract again, when cooling down. A sintered connection layer 60 may have an expansion coefficient of CTE_{Ag} ~ 19 ppm/K, for example. The expansion coefficient of a (sintered) connection layer 60 usually considerably differs from the expansion coefficient of the base plate 80, from the expansion coefficient of the substrate 10, as well as from the expansion coefficient of a semiconductor body 20. For example, the expansion coefficient of the substrate 10 may be between CTE_{Substrate} ~ 5 ppm/K and CTE_{Substrate} ~ 8 ppm/K. The base plate 80 may comprise or consist of copper, for example. Copper generally has an expansion coefficient of about 17ppm/K, that is CTE_{Copper} ~ 17 ppm/K. The semiconductor bodies 20 may comprise or consist of Si or SiC, for example. Silicon, Si, generally has an expansion coefficient of about 2.6 ppm/K, that is CTE_{Si} ~ 2.6 ppm/K, and silicon carbide, SiC, generally has an expansion coefficient of about 4.0 ppm/K, that is CTE_{SiC} ~ 4.0 ppm/K. The given values are, however, only examples. Other values of the CTEs of the different components are generally also possible.

Over the lifetime of the semiconductor module arrangement 100, the semiconductor bodies 20 are heated and cooled many times, as they are repeatedly switched on and off. Due to the different CTEs of the different components, the thermally-induced mechanical stress on the connection layer(s) 60 can be quite high. The cyclic heating and cooling of the semiconductor bodies 20 and, therefore, of the connection layer(s) 60 may result in a mechanical fatigue of the connection layer(s) 60 and/or the adjoining connection partners. Stresses are usually especially high towards the edges of a component, e.g., towards the edges of a semiconductor body 20 or towards the edges of the substrate 10. The mechanical fatigue may result in cracks or ruptures in the respective connection layer 60, especially in areas of the connection layer 60 arranged below or close to the edges of the component (e.g., semiconductor body 20 or substrate 10). Such cracks or ruptures may severely weaken the connection between the semiconductor body 20 and the substrate 10, or between the substrate 10 and the base plate 80, and may severely limit the durability and thermal conductivity of the respective connection layer 60 which may, eventually, result in a failure of the semiconductor module arrangement 100. The formation of cracks or ruptures in a connection layer 60 may be reduced or even avoided by increasing the thickness of the connection layer 60. As mentioned above, a connection layer 60 often comprises a sintered silver (Ag) powder or a sintered copper (Cu) powder, which is comparably expensive. Therefore, by increasing the thickness of the connection layer 60, the costs of a semiconductor module arrangement may increase significantly, especially if a surface area of the respective connection layer 60 is large, which is the case, for example, for a connection layer 60 connecting the substrate 10 to a base plate 80.

Now referring to Figure 2, in order to avoid cracks or ruptures from forming in a connection layer 60, thereby reducing the risk of the arrangement from failing, an arrangement according to embodiments of the present disclosure comprises a first connection partner 90, a second connection partner 92, and a connection layer 60 arranged between the first connection partner 90 and the second connection partner 92, and mechanically connecting the second connection partner 92 to the first connection partner 90. The connection layer 60 comprises a first sinter layer 602, a metal layer 604, and a second sinter layer 606, wherein the first sinter layer 602 is arranged between the metal layer 604 and the first connection partner 90 and directly contacts the first connection partner 90, and the second sinter layer 606 is arranged between the metal layer 604 and the second connection partner 92 and directly contacts the second connection partner 92.

The first sinter layer 602 and the second sinter layer 606 may comprise a sintered silver (Ag) powder, or a sintered copper (Cu) powder, for example. The metal layer 604 (or metal film) may consist of copper, a copper alloy, aluminum, an aluminum alloy, nickel, a nickel alloy, gold, a gold alloy, molybdenum or a molybdenum alloy, for example. It is generally also possible that the metal layer 604 comprises or consists of other materials such as, e.g., silver (Ag) or a silver alloy. However, silver, for example, when deposited as a film is generally more expensive than, e.g., copper. In this way, the overall costs of the connection layer 60 can be significantly reduced by forming a (significant) part of a thick connection layer 60 from a comparably cheap material that can be easily deposited to form the metal layer 604. On the other hand, the metal layer 604 also has a different CTE than the first and second sinter layers 602, 606. That is, the overall CTE of the connection layer 60 according to embodiments of the present disclosure differs from the CTE of a thick sinter layer without a metal layer 604. This further helps to avoid cracks or ruptures from forming in a connection layer 60 during the use of the semiconductor module.

The connection layer 60 has a first thickness d60 in a vertical direction y perpendicular to a top surface of the first connection partner 90, wherein the top surface of the first connection partner 90 is a surface facing towards the second connection partner 92. The metal layer 604 has a second thickness d604 in the vertical direction y. According to some embodiments of the present disclosure, the second thickness d604 may be between 45% and 98% of the first thickness d60, or between 60% and 90% of the first thickness, or between 75% and 85% of the first thickness d60. That is, a significant share of the connection layer 60 may be formed by the comparably cheap metal layer 604. The connection layer 60 may have a first thickness d60 of between 100µm and 600µm, between 150µm and 300µm, or between 200µm and 250µm, for example.

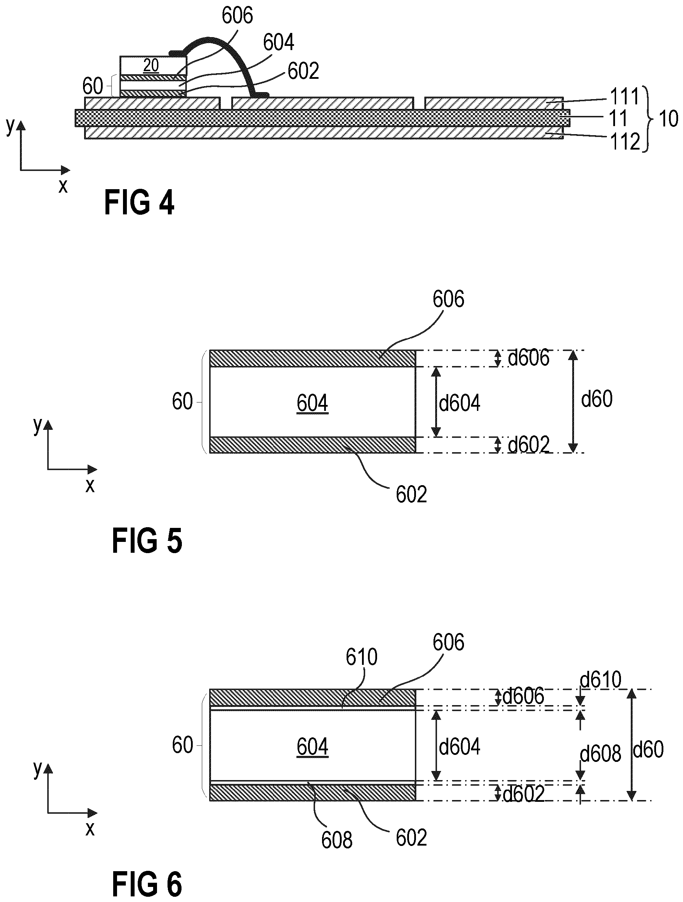

As mentioned, the arrangement may be arranged in a semiconductor module arrangement. Now referring to Figure 3, the first connection partner 90 may be a base plate 80, and the second connection partner 92 may be a substrate 10 of the semiconductor module arrangement. Referring to Figure 4, according to further embodiments of the disclosure, the first connection partner 90 may be a substrate 10, and the second connection partner 92 may be a semiconductor body 20 of the semiconductor module arrangement.

According to some examples, the base plate 80 may comprise or consist of copper, a copper alloy, or AlSiC. Other metals or metal alloys, however, are generally also possible. The dielectric insulation layer 11 of the substrate 10 may consist of AIN, for example. As mentioned above, the first and second metallization layers 111, 112 of the substrate 10 may consist of or include one of the following materials: copper; a copper alloy; aluminum; an aluminum alloy; any other metal or alloy that remains solid during the operation of the semiconductor module arrangement. For such materials, a difference of the CTEs of the base plate 80 and the substrate 10 is especially high, and the effects of the connection layer 60 according to embodiments of the disclosure will be comparably pronounced. As mentioned, the metal layer 604 may consist of copper or a copper alloy, for example. That is, in some examples, the metal layer 604 may consist of the same material as the base plate 80, or may consist of a material that is highly similar to the material of the base plate 80.

Now referring to Figure 5, the first sinter layer 602 may directly contact the metal layer 604, and the second sinter layer 606 may directly contact the metal layer 604. That is, the first sinter layer 602 may attach the metal layer 604 to the first connection partner 90, and the second sinter layer 606 may attach the metal layer 604 to the second connection partner 92. According to alternative embodiments, and as is schematically illustrated in Figure 6, for example, the connection layer 60 may further comprise a first coating layer 608 and a second coating layer 610, wherein the first coating layer 608 is arranged between and directly contacts the metal layer 604 and the first sinter layer 602, and the second coating layer 610 is arranged between and directly contacts the metal layer 604 and the second sinter layer 606. That is, the metal layer 604 may be a coated metal layer 604. The first coating layer 608 and the second coating layer 610, according to some embodiments of the disclosure, may each comprise or consist of a noble metal. For example, the first coating layer 608 and the second coating layer 610 may each comprise at least 95% by volume of silver or gold.

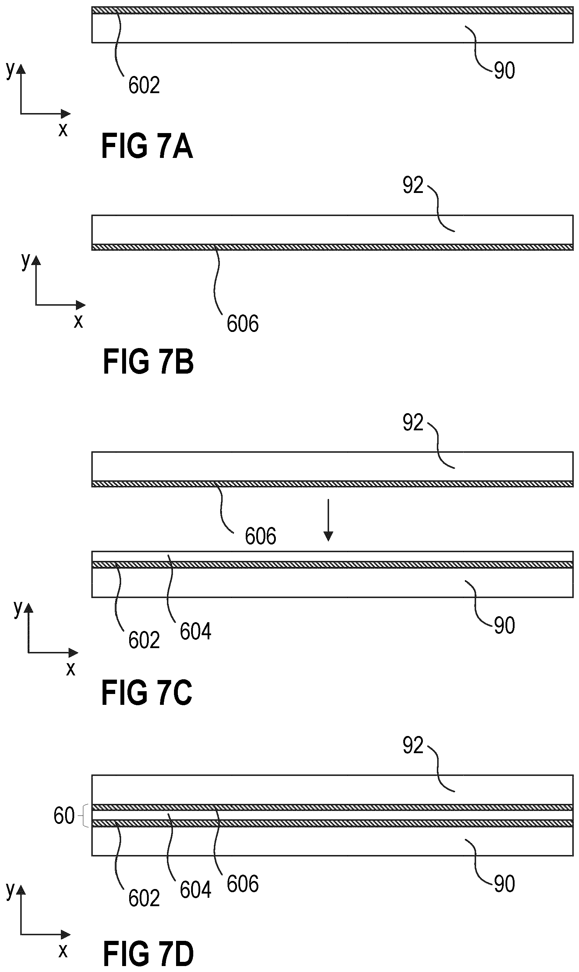

Now referring to Figure 7, especially to Figure 7D, a method according to embodiments of the present disclosure is schematically illustrated. The method comprises forming a connection layer 60 between a first connection partner 90 and a second connection partner 92, and mechanically connecting the second connection partner 92 to the first connection partner 90 by means of the connection layer 60. The connection layer 60 comprises a first sinter layer 602, a metal layer 604, and a second sinter layer 606, wherein the first sinter layer 602 is arranged between the metal layer 604 and the first connection partner 90 and directly contacts the first connection partner 90, and the second sinter layer 606 is arranged between the metal layer 604 and the second connection partner 92 and directly contacts the second connection partner 92.

According to some embodiments, and as is schematically illustrated in Figures 7A, 7B, and 7C, forming the connection layer 60 between the first connection partner 90 and the second connection partner 92 may comprise forming the first sinter layer 602 on a surface of the first connection partner 90 (Figure 7A), forming the second sinter layer 606 on a surface of the second connection partner 92 (Figure 7B), arranging the metal layer 604 on the first sinter layer 602 or on the second sinter layer 606 (Figure 7C), and arranging the second connection partner 92 on the first connection partner 90 such that the metal layer 604 is arranged between the first sinter layer 602 and the second sinter layer 606 (Figure 7D). Alternatively, the first and second sinter layers 602, 606 may be formed on opposed sides of the metal layer 604 to form the connection layer 600 prior to assembly. This pre-formed connection layer 600 may then be arranged between the first connection partner 90 and the second connection partner 92 in preparation for sintering.

At least one sintering step may follow to connect the second connection partner 92 to the first connection partner 90 by means of the connection layer 60, for example. According to one embodiment of the present disclosure, the connection layer 60 comprising the first sinter layer 602, the metal layer 604, and the second sinter layer 606 is formed between the first connection partner 90 and the second connection partner 92, and the first and second sinter layers 602, 606 are sintered simultaneously in one and the same step. Alternatively, however, it is generally also possible that the metal layer 604 is arranged on the first connection partner 90 with the first sinter layer 602 arranged between the metal layer 604 and the first connection partner 90, and that in a first step, the first sinter layer 602 is sintered to attach the metal layer 604 to the first connection partner 90. In a subsequent step, the second connection partner 92 may then be attached to the metal layer 604, and, consequently, to the first connection partner 90 by means of the second sinter layer 606.

It is also possible that, for example, the first sinter layer 602 is formed on a surface of the first connection partner 90, and the second sinter layer 606 is formed on a surface of the metal layer 604. Alternatively, the first sinter layer 602 may be formed on a surface of the metal layer 604, and the second sinter layer 606 may be formed on a surface of the second connection partner 92. It is even possible, according to alternative embodiments, that the first sinter layer 602 is formed on a first surface of the metal layer 604, and the second sinter layer 606 is formed on a second surface of the metal layer 604, opposite the first surface, and that the metal layer 604 with the first and second sinter layer 602, 606 formed thereon is arranged between the first connection partner 90, and the second connection partner 92.

The different layers 602, 604, 606 may be formed by means of any suitable methods. According to some embodiments of the present disclosure, forming the first sinter layer 602 on a surface of the first connection partner 90 or the metal layer 604 may comprise a (screen) printing method, a dispensing method, a spraying process or a lamination process, and, similarly, forming the second sinter layer 606 on a surface of the second connection partner 92 or the opposed side of the metal layer 604 may comprise a (screen) printing method, a dispensing method, a spraying process, or a lamination process. Arranging the metal layer 604 on the first sinter layer 602 or on the second sinter layer 606 may comprise arranging a pre-fabricated metal sheet on the first sinter layer 602 or on the second sinter layer 606, for example.

## Claims

1. An arrangement comprises
a first connection partner (90);
a second connection partner (92); and
a connection layer (60) arranged between the first connection partner (90) and the second connection partner (92), and mechanically connecting the second connection partner (92) to the first connection partner (90), wherein
the connection layer (60) comprises a first sinter layer (602), a metal layer (604), and a second sinter layer (606), wherein the first sinter layer (602) is arranged between the metal layer (604) and the first connection partner (90) and directly contacts the first connection partner (90), and the second sinter layer (606) is arranged between the metal layer (604) and the second connection partner (92) and directly contacts the second connection partner (92).

2. The arrangement of claim 1, wherein
the connection layer (60) has a first thickness (d60) in a vertical direction (y) perpendicular to a top surface of the first connection partner (90), wherein the top surface of the first connection partner (90) is a surface facing towards the second connection partner (92), and
the metal layer (604) has a second thickness (d604) in the vertical direction (y),
wherein the second thickness (d604) is between 45% and 98% of the first thickness (d60), or between 60% and 90% of the first thickness (d60) or between 75% and 85% of the first thickness (d60).

3. The arrangement of claim 1 or 2, wherein the metal layer (604) consists of copper, a copper alloy, aluminum, an aluminum alloy, nickel, or a nickel alloy.

4. The arrangement of any of claims 1 to 3, wherein the first sinter layer (602) and the second sinter layer (606) comprise a sintered silver (Ag) powder, or a sintered copper (Cu) powder.

5. The arrangement of any of the preceding claims, wherein the first sinter layer (602) directly contacts the metal layer (604), and the second sinter layer (606) directly contacts the metal layer (604).

6. The arrangement of any of claims 1 to 4, wherein the connection layer (60) further comprises a first coating layer (608) and a second coating layer (610), wherein
the first coating layer (608) is arranged between and directly contacts the metal layer (604) and the first sinter layer (602), and
the second coating layer (610) is arranged between and directly contacts the metal layer (604) and the second sinter layer (606).

7. The arrangement of claim 6, wherein the first coating layer (608) and the second coating layer (610) each comprise or consist of a noble metal.

8. The arrangement of claim 7, wherein the first coating layer (608) and the second coating layer (610) each comprise at least 95% by volume of silver or gold.

9. The arrangement of any of the preceding claims, wherein the connection layer (60) has a first thickness (d60) in a vertical direction (y) perpendicular to a top surface of the first connection partner (90), wherein the first thickness (d60) is between 100µm and 600µm, between 150µm and 300µm, or between 200µm and 250µm.

10. The arrangement of any of the preceding claims, wherein the arrangement is arranged in a semiconductor module arrangement.

11. The arrangement of claim 10, wherein
the first connection partner (90) is a base plate (80), and the second connection partner (92) is a substrate (10) of the semiconductor module arrangement, or
the first connection partner (90) is a substrate (10), and the second connection partner (92) is a semiconductor body (20) of the semiconductor module arrangement.

12. A method comprising
forming a connection layer (60) between a first connection partner (90) and a second connection partner (92); and
mechanically connecting the second connection partner (92) to the first connection partner (90) by means of the connection layer (60), wherein
the connection layer (60) comprises a first sinter layer (602), a metal layer (604), and a second sinter layer (606), wherein the first sinter layer (602) is arranged between the metal layer (604) and the first connection partner (90) and directly contacts the first connection partner (90), and the second sinter layer (606) is arranged between the metal layer (604) and the second connection partner (92) and directly contacts the second connection partner (92).

13. The method of claim 12, wherein forming the connection layer (60) between the first connection partner (90) and the second connection partner (92) comprises
forming the first sinter layer (602) on a surface of the first connection partner (90);
forming the second sinter layer (606) on a surface of the second connection partner (92);
arranging the metal layer (604) on the first sinter layer (602) or on the second sinter layer (606); and
arranging the second connection partner (92) on the first connection partner (90) such that the metal layer (604) is arranged between the first sinter layer (602) and the second sinter layer (606).

14. The method of claim 13, wherein
forming the first sinter layer (602) on a surface of the first connection partner (90) comprises a printing method, a dispensing method, or a lamination process; and
forming the second sinter layer (606) on a surface of the second connection partner (92) comprises a printing method, a dispensing method, or a lamination process.

15. The method of any of claims 13 or 14, wherein arranging the metal layer (604) on the first sinter layer (602) or on the second sinter layer (606) comprises arranging a pre-fabricated metal sheet on the first sinter layer (602) or on the second sinter layer (606).

16. The method of claim 12, wherein forming the connection layer (60) between the first connection partner (90) and the second connection partner (92) comprises
forming the first sinter layer (602) on a first surface of the metal layer (604); forming the second sinter layer (606) on a second surface of the metal layer (604) opposite the first surface of the metal layer (604);
arranging the metal layer (604) between the first connection partner (90) and the second connection partner (92).

## Amended claims

### Amended claims in accordance with Rule 137(2) EPC.

1. An arrangement comprises
a first connection partner (90);
a second connection partner (92); and
a connection layer (60) arranged between the first connection partner (90) and the second connection partner (92), and mechanically connecting the second connection partner (92) to the first connection partner (90), wherein
the connection layer (60) comprises a first sinter layer (602), a metal layer (604), and a second sinter layer (606), wherein the first sinter layer (602) is arranged between the metal layer (604) and the first connection partner (90) and directly contacts the first connection partner (90), and the second sinter layer (606) is arranged between the metal layer (604) and the second connection partner (92) and directly contacts the second connection partner (92),
the connection layer (60) has a first thickness (d60) in a vertical direction (y) perpendicular to a top surface of the first connection partner (90), wherein the top surface of the first connection partner (90) is a surface facing towards the second connection partner (92), and
the metal layer (604) has a second thickness (d604) in the vertical direction (y), wherein the second thickness (d604) is between 45% and 98% of the first thickness (d60).

2. The arrangement of claim 1, wherein
the second thickness (d604) is between 60% and 90% of the first thickness (d60) or between 75% and 85% of the first thickness (d60).

3. The arrangement of claim 1 or 2, wherein the metal layer (604) consists of copper, a copper alloy, aluminum, an aluminum alloy, nickel, or a nickel alloy.

4. The arrangement of any of claims 1 to 3, wherein the first sinter layer (602) and the second sinter layer (606) comprise a sintered silver (Ag) powder, or a sintered copper (Cu) powder.

5. The arrangement of any of the preceding claims, wherein the first sinter layer (602) directly contacts the metal layer (604), and the second sinter layer (606) directly contacts the metal layer (604).

6. The arrangement of any of claims 1 to 4, wherein the connection layer (60) further comprises a first coating layer (608) and a second coating layer (610), wherein
the first coating layer (608) is arranged between and directly contacts the metal layer (604) and the first sinter layer (602), and
the second coating layer (610) is arranged between and directly contacts the metal layer (604) and the second sinter layer (606).

7. The arrangement of claim 6, wherein the first coating layer (608) and the second coating layer (610) each comprise or consist of a noble metal.

8. The arrangement of claim 7, wherein the first coating layer (608) and the second coating layer (610) each comprise at least 95% by volume of silver or gold.

9. The arrangement of any of the preceding claims, wherein the connection layer (60) has a first thickness (d60) in a vertical direction (y) perpendicular to a top surface of the first connection partner (90), wherein the first thickness (d60) is between 100µm and 600µm, between 150µm and 300µm, or between 200µm and 250µm.

10. The arrangement of any of the preceding claims, wherein the arrangement is arranged in a semiconductor module arrangement.

11. The arrangement of claim 10, wherein
the first connection partner (90) is a base plate (80), and the second connection partner (92) is a substrate (10) of the semiconductor module arrangement, or
the first connection partner (90) is a substrate (10), and the second connection partner (92) is a semiconductor body (20) of the semiconductor module arrangement.

12. A method comprising
forming a connection layer (60) between a first connection partner (90) and a second connection partner (92); and
mechanically connecting the second connection partner (92) to the first connection partner (90) by means of the connection layer (60), wherein
the connection layer (60) comprises a first sinter layer (602), a metal layer (604), and a second sinter layer (606), wherein the first sinter layer (602) is arranged between the metal layer (604) and the first connection partner (90) and directly contacts the first connection partner (90), and the second sinter layer (606) is arranged between the metal layer (604) and the second connection partner (92) and directly contacts the second connection partner (92),
the connection layer (60) has a first thickness (d60) in a vertical direction (y) perpendicular to a top surface of the first connection partner (90), wherein the top surface of the first connection partner (90) is a surface facing towards the second connection partner (92), and
the metal layer (604) has a second thickness (d604) in the vertical direction (y), wherein the second thickness (d604) is between 45% and 98% of the first thickness (d60).

13. The method of claim 12, wherein forming the connection layer (60) between the first connection partner (90) and the second connection partner (92) comprises
forming the first sinter layer (602) on a surface of the first connection partner (90);
forming the second sinter layer (606) on a surface of the second connection partner (92);
arranging the metal layer (604) on the first sinter layer (602) or on the second sinter layer (606); and
arranging the second connection partner (92) on the first connection partner (90) such that the metal layer (604) is arranged between the first sinter layer (602) and the second sinter layer (606).

14. The method of claim 13, wherein
forming the first sinter layer (602) on a surface of the first connection partner (90) comprises a printing method, a dispensing method, or a lamination process; and
forming the second sinter layer (606) on a surface of the second connection partner (92) comprises a printing method, a dispensing method, or a lamination process.

15. The method of any of claims 13 or 14, wherein arranging the metal layer (604) on the first sinter layer (602) or on the second sinter layer (606) comprises arranging a prefabricated metal sheet on the first sinter layer (602) or on the second sinter layer (606).

16. The method of claim 12, wherein forming the connection layer (60) between the first connection partner (90) and the second connection partner (92) comprises
forming the first sinter layer (602) on a first surface of the metal layer (604);
forming the second sinter layer (606) on a second surface of the metal layer (604) opposite the first surface of the metal layer (604);
arranging the metal layer (604) between the first connection partner (90) and the second connection partner (92).
